Europäisches Patentamt

(19) European Patent Office

Office européen des brevets

(11) Numéro de publication : **0 029 378**
**B1**

(12) **FASCICULE DE BREVET EUROPÉEN**

(45) Date de publication du fascicule du brevet :
**15.12.82**

(21) Numéro de dépôt : **80401566.7**

(22) Date de dépôt : **03.11.80**

(51) Int. Cl.³ : **G 11 C 19/08**

(54) **Registre à décalage à propagation de domaines magnétiques et mémoire constituée par ces registres.**

(30) Priorité : **07.11.79 FR 7927447**

(43) Date de publication de la demande :
**27.05.81 (Bulletin 81/21)**

(45) Mention de la délivrance du brevet :
**15.12.82 Bulletin 82/50**

(84) Etats contractants désignés :
**DE GB IT NL**

(56) Documents cités :
**FR A 2 206 558**
**FR A 2 406 284**

(73) Titulaire : **CROUZET**
**128, Avenue de la République**
**F-75011 Paris (FR)**

(72) Inventeur : **Battarel, Claude**
**La Chaumière F-06520 Magagnosc**
**FR (FR)**

(74) Mandataire : **Bloch, Robert et al**
**Cabinet ROBERT BLOCH 39 avenue de Friedland**
**F-75008 Paris (FR)**

## Registre à décalage à propagation de domaines magnétiques et mémoire constituée par ces registres

La présente invention concerne un registre à décalage pour mémoire à propagation de domaines magnétiques, comportant une couche magnétique douce dans laquelle s'effectue la propagation des domaines, une couche magnétique dure et un conducteur de décalage des domaines, le canal de propagation des domaines dans la couche douce étant défini par une interruption de la couche dure, et comportant des zones rétrécies de stockage des domaines, des cases élargies de croissance des domaines, une case d'écriture et une case de lecture, et le conducteur de décalage, en forme de grecque, comportant des segments perpendiculaires au canal de propagation.

Un tel registre est notamment décrit dans la demande de brevet français publiée sous le numéro 2 406 284.

L'invention concerne plus particulièrement la lecture des domaines à l'extrémité aval du canal de propagation des domaines, par exemple par une magnétorésistance de lecture disposée sur la case de lecture du canal de propagation.

On s'est déjà attaché, dès l'apparition de ces registres à décalage, à obtenir un niveau de lecture qui soit maximal avec, à cet effet, une case de lecture étendue et une structure de registre permettant l'éclatement des domaines et, par conséquent, le remplissage de cette case de lecture avec un domaine également étendu, le niveau de lecture dépendant de la quantité de charges magnétostatiques à l'extrémité aval du domaine. Un registre à décalage utilisant un procédé d'éclatement des domaines afin d'améliorer l'amplitude du signal de lecture est décrit dans la demande de brevet français FR 2 206 558. L'éclatement des domaines, en un nombre déterminé de domaines, selon évidemment l'axe difficile de la couche douce, et donc le remplissage de la case de lecture à partir de plusieurs domaines, présente déjà un avantage. En effet, comme le temps de croissance latérale, c'est-à-dire perpendiculairement à la direction de propagation des domaines, est beaucoup plus long que le temps de croissance des domaines par les pointes, c'est-à-dire dans la direction de propagation des domaines le long de l'axe aisé, le temps de lecture, dans ce cas, comparé à celui qui est nécessaire lorsque la case de lecture n'est remplie qu'à partir d'un seul domaine élargi dans cette case par le conducteur de décalage, est divisé par un nombre égal à la quantité des domaines éclatés.

En outre, l'éclatement des domaines permet de ne pas faire passer le conducteur de décalage, et donc d'élargissement, sur la case de lecture, et de disposer par conséquent la magnétorésistance de lecture sur la case de lecture, au même niveau que le conducteur de décalage.

Toutefois, cet éclatement des domaines doit s'effectuer par l'intermédiaire de cases d'élargissement. Or la structure des registres connus jusqu'à ce jour était telle qu'on ne pouvait pas envisager l'auto-effacement de ces cases d'élargissement intermédiaires et qu'il fallait prévoir, soit des conducteurs d'effacement, soit et, de préférence, un seul et même conducteur d'effacement mais avec plusieurs passages consécutifs dans le même sens au-dessus de ces cases intermédiaires. Même si le conducteur de décalage servait en même temps de conducteur d'effacement, cela posait un problème de topologie, à cause de l'entourage multiple par le conducteur des plots ou bornes de sortie de celui-ci. De toutes manières, l'accroissement des domaines dans les cases intermédiaires d'élargissement requérait également plusieurs passages consécutifs et dans le même sens du conducteur de décalage, pour préserver la densité de courant le long des cases intermédiaires. Les registres connus posaient donc ce problème de topologie.

La présente invention vise à éliminer ce problème et, en conséquence, à faciliter la fabrication des registres à propagation de domaines.

A cet effet, la présente invention concerne un registre à décalage pour mémoire à propagation des domaines magnétiques du type défini ci-dessus avec, en amont de la case de lecture, une zone d'élargissement comportant des cases intermédiaires d'élargissement des domaines séparées entre elles, dans le sens de la propagation, par des zones de stockage, caractérisé par le fait que les cases d'élargissement intermédiaires ont une surface importante par rapport à celle des autres cases de croissance et comportent au moins un décrochement latéral, qu'elles ne sont pas recouvertes par le conducteur de décalage, et qu'il est prévu des moyens pour créer, au moins au niveau de la zone d'élargissement et de la case de lecture, un champ magnétique externe pulsé.

Grâce au décrochement des cases d'élargissement intermédiaires qui y crée un champ statique démagnétisant, les domaines magnétiques y sont effacés dans les intervalles de temps où le champ magnétique externe pulsé disparaît. Quant à la propagation et à l'élargissement des domaines dans la zone d'élargissement, c'est précisément ce champ externe qui les assure, les cases d'élargissement n'étant pas soumises à l'action du champ créé par les conducteurs de décalage.

La présente invention permet donc avantageusement de dédoubler les fonctions propagation-élargissement des domaines et effacement des domaines.

Par ailleurs, grâce à l'étendue des cases d'élargissement intermédiaires, les champs statiques démagnétisants qui y règnent, tout en étant suffisants pour effacer les domaines, sont toutefois suffisamment faibles pour ne pas s'opposer à la croissance des domaines, notamment dans le sens latéral, sous l'action du champ externe.

Dans une forme de réalisation préférée du registre de l'invention, lesdits moyens sont agencés pour créer un champ magnétique externe pulsé sur tout le registre.

Dans ce cas, l'invention procure un avantage supplémentaire. En effet, sans champ externe, les domaines ne s'engagent pas complètement dans les zones rétrécies de stockage du canal de propagation.

Avec ce champ externe, selon l'invention, les domaines s'étendent jusqu'à l'extrémité aval des zones de stockage. Et lorsque le courant dans le conducteur de décalage s'annule, le champ externe reste encore insuffisant pour faire rentrer le domaine dans les cases de croissance. Ce n'est qu'à l'alternance suivante du courant de décalage que les domaines croissent dans les cases élargies. En conséquence, les domaines transitoires du registre de l'invention sont plus longs que ceux des registres connus, ce qui permet, à structure de registre comparable, d'obtenir une densité de stockage de l'information plus importante.

Les moyens agencés pour créer le champ externe pulsé peuvent être constitués par une bobine plate ou un solénoïde aplati.

L'invention sera mieux comprise à la lecture suivante de la description de plusieurs formes de réalisation du registre de l'invention, en référence au dessin annexé, sur lequel :

La figure 1 est une vue en plan d'une première forme de réalisation du circuit de propagation des domaines du registre de l'invention ;

la figure 2 est une vue en coupe du canal de propagation du registre de la figure 1 ;

la figure 3 est une vue en perspective du registre de l'invention avec une bobine plate pour créer un champ externe ;

la figure 4 est une vue en perspective du registre de l'invention avec un solénoïde aplati pour créer un champ externe ;

la figure 5 est une vue en plan d'une deuxième forme de réalisation de la zone d'éclatement des domaines du registre de l'invention, et

la figure 6 est une vue schématique de plusieurs registres selon l'invention, intégrés sur un même substrat.

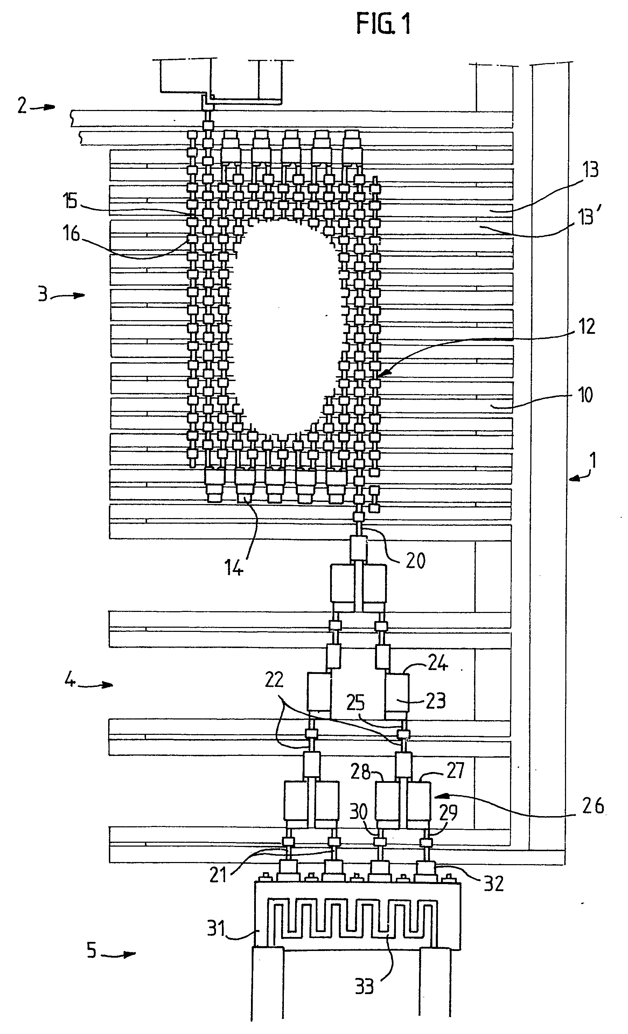

La figure 1 représente une vue en plan du circuit de propagation de domaines dans une première forme de réalisation 1 du registre mémoire de l'invention. Le registre 1 comporte quatre zones successives, à savoir une zone 2 d'écriture des domaines classique, une zone 3 de propagation des domaines, une zone 4 d'élargissement des domaines et une zone 5 de lecture des domaines.

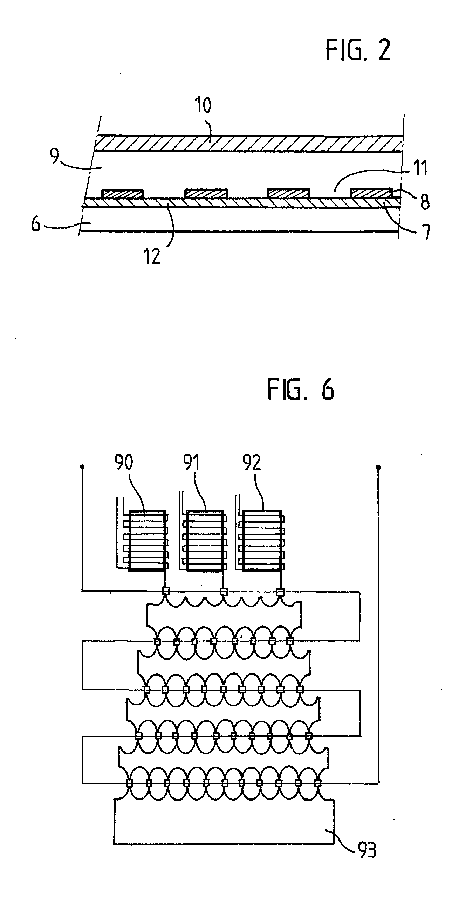

On a représenté, sur la figure 2, une vue en coupe de la zone de propagation 3. Le registre comporte dans cette zone, et de façon connue, un substrat monocristallin 6, ou un autre matériau à surface spéculaire, une couche magnétique douce 7 à anisotropie uniaxiale, une couche magnétique dure 8, déposée en contact intime sur la couche douce 7, sauf le long d'un circuit 11, pour définir dans la couche douce le circuit de propagation 12 des domaines, une couche isolante 9 et une couche conductrice 10, pour le décalage des domaines dans leur circuit de propagation 12. Le conducteur de décalage 10 est disposé en forme de grecque, et comporte ainsi des paires de segments parallèles 13 et 13', destinés à être parcourus en sens inverses par un courant alternatif pulsé de décalage et disposés les uns à côté des autres selon un pas déterminé, sensiblement égal, en l'espèce, à la largeur de ces segments. Le circuit de propagation 12 comporte des segments parallèles à l'axe d'anisotropie uniaxiale de la couche magnétique douce 7, perpendiculaires aux segments du conducteur de décalage, et réunis entre eux deux par des cases ou coudes de repliement 14. Chaque segment du circuit de propagation 12, entre ses deux coudes de repliement d'extrémité, comporte des zones rétrécies 15 de stockage des domaines et des cases élargies 16 de croissance des domaines entre une case de stockage amont et une case de stockage aval, les cases élargies étant disposées alternativement sous les segments 13 et 13' du conducteur de décalage.

Dans la zone 4 d'élargissement des domaines, le registre possède, de façon générale, une structure similaire à celle de la zone de propagation 3 avec, toutefois, les caractéristiques de l'invention suivantes.

Le conducteur de décalage ne comporte plus que quelques paires de segments parallèles 13, 13' espacées entre elles d'un nombre donné de pas des segments conducteurs de la zone de propagation 3. Dans la forme de la réalisation de la figure 1, la zone 4 ne comporte que trois paires de segments conducteurs 13, 13', espacées entre elles deux à deux d'une distance égale à quatre fois le pas des segments de la zone de propagation. Le circuit de propagation des domaines, dans cette zone 4, est agencé pour provoquer l'éclatement des domaines en un nombre déterminé de domaines, dans le but d'obtenir un niveau de lecture qui soit maximal. Dans l'exemple représenté, on obtient, à partir d'un domaine, et au bout de six temps d'horloge, quatre domaines qui vont remplir la case de lecture.

Le circuit de propagation de la zone 4 part d'une case rétrécie de stockage des domaines 20 et aboutit à un nombre n donné, en l'espèce 4, de cases de stockage 21, disposées juste en amont de la zone de lecture 5. Entre la case 20 et ces cases 21, le canal de propagation comporte des cases intermédiaires d'élargissement des domaines. Le canal se divise en deux, une première fois, à la sortie de la case de stockage 20, chacun des deux segments du canal issus de cette case 20, se divisant également en deux, à la sortie de cases de stockage 22 situées sous la deuxième paire de segments conducteurs de cette zone 4. Sous chaque paire de segments conducteurs se trouvent, dans le sens de propagation, une première case de stockage, sous le premier segment conducteur, une case de croissance, semblable à celles de la zone de la propagation 3, et une deuxième case de stockage, sous le deuxième segment conducteur. Dans l'exemple représenté, les cases de stockage 22 et 21 sont des dites deuxièmes cases de stockage disposées respectivement sous le deuxième segment conducteur des deuxième et troisième paires de segments conducteurs.

Les cases d'élargissement intermédiaires de cette zone 4, de forme générale rectangulaire, présentent trois particularités. En premier lieu, elles sont disposées entre une deuxième case de stockage sous une paire de segments conducteurs et une première case de stockage sous la paire de segments conducteurs suivante, c'est-à-dire qu'elles ne sont pas recouvertes par le conducteur de décalage.

En second lieu, elles comportent au moins un décrochement latéral, dans la direction perpendiculaire au sens de propagation. On a ainsi prévu des cases d'élargissement intermédiaires simples 23, entre la première et la deuxième paire de segments conducteurs, comportant un seul décrochement latéral 24 et, par conséquent, une seule sortie sur une seule première case de stockage rétrécie 25, et des cases d'élargissement intermédiaires doubles 26, une juste en amont de la première paire de segments conducteurs, et deux entre les deuxième et troisième paires de segments conducteurs, comportant chacune deux décrochements latéraux 27, 28 en sens opposés, et par conséquent deux sorties sur deux premières cases de stockage rétrécies 29, 30.

Dans la forme de réalisation de la figure 1, les décrochements 24, 27, 28 sont tels que les cases d'élargissement possèdent des petits côtés, perpendiculaires à l'axe aisé de la couche magnétique douce, sur lesquels s'accumulent des charges magnétostatiques négatives, sur les côtés amont, et des charges magnétostatiques positives, sur les côtés aval. Ces charges créent dans les cases 23 et 26 un champ statique démagnétisant.

Enfin, les cases d'élargissement intermédiaires ont une surface importante, comparativement à celle des cases de croissance, de cette zone et de la zone de propagation 3.

En aval de la zone d'élargissement 4 précédemment décrite, se situe la zone de lecture 5, comportant une très grande case de lecture 31, raccordée aux quatre sorties 21 de la zone 4 par quatre cases de croissance 32, et une magnétorésistance de lecture 33, disposée directement sur la case 31, au même niveau que le conducteur de décalage 10, celui-ci ne passant pas sur la case de lecture.

Le conducteur de décalage étant, de façon connue en soi, parcouru par des impulsions de courant pour créer un champ magnétique « interne », il est prévu, conformément à l'invention, de superposer à ce champ interne un champ magnétique externe pulsé, parallèle à la direction de propagation des domaines.

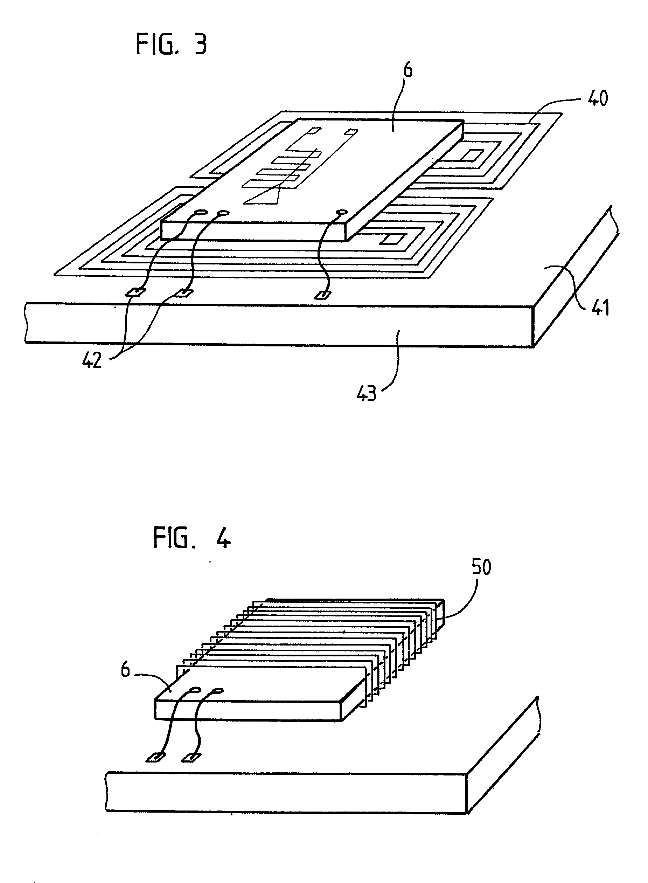

Ainsi, on a prévu dans la forme de réalisation de la figure 3, de créer ce champ auxiliaire en envoyant un courant pulsé, de même signe, dans une bobine plate 40, située en dessous du substrat mémoire 6. La bobine 40 est constituée d'un conducteur déposé sur un substrat de céramique 41, sur lequel on a également déposé les plots de reprise de contact 42 (non représentés sur la figure 1) du conducteur 10 qui est déposé sur le substrat mémoire 6. La réalisation de la bobine 40 est économique, car elle ne requiert ni assemblage, ni étape de fabrication supplémentaire. Le substrat 41 de la bobine est disposé dans une embase de boîtier 43.

Dans la forme de réalisation de la figure 4, le champ magnétique auxiliaire externe est créé par un petit solénoïde aplati 50 entourant le substrat mémoire 6. La fabrication de ce solénoïde est également économique et on peut facilement et directement faire passer les connexions des plots du substrat mémoire à travers les deux ouvertures du solénoïde.

On a vu plus haut que le champ auxiliaire externe était parallèle à la direction de propagation des domaines. Bien qu'il ne s'agisse pas d'une condition impérative, il est toutefois préférable de la respecter pour éviter les nucléations parasites.

Le registre de l'invention ayant maintenant été décrit, on peut aborder les aspects essentiels de son fonctionnement.

Comme on l'a vu plus haut, les décrochements 24, 27 et 28 créent dans les cases intermédiaires d'élargissement des domaines 23 et 26 un champ statique démagnétisant. Dans les intervalles de temps où le champ externe pulsé, créé par la bobine 40, ou le solénoïde 50, disparaît, les domaines magnétiques y sont effacés. Lorsque ce champ magnétique externe n'est pas nul, c'est lui qui assure, dans la zone 4 d'éclatement des domaines, la propagation et l'élargissement des domaines magnétiques, les cases d'élargissement 23 et 26 n'étant pas recouvertes par le conducteur de décalage 10, et n'étant pas, de ce fait, soumises au champ magnétique créé par ce conducteur.

La présente invention permet donc de séparer, dans la zone d'éclatement des domaines, les fonctions propagation-élargissement, d'une part, et effacement, d'autre part. Il faut noter que, grâce à l'étendue des cases intermédiaires 23 et 26, les champs statiques démagnétisants qui y règnent, tout en étant suffisants pour effacer les domaines, sont toutefois insuffisants pour s'opposer à la croissance des domaines sous l'action du champ auxiliaire.

Grâce au champ magnétique externe créé par la bobine 40, ou le solénoïde 50, sur tout le registre 1, les domaines s'étendent jusqu'à l'extrémité aval des cases de stockage 15. Et lorsque le courant dans le conducteur de décalage 10 s'annule, le champ auxiliaire externe reste insuffisant pour faire entrer les domaines dans les cases de croissance 16. Ce n'est qu'à l'alternance suivante du courant dans le conducteur 10 que les domaines croissent dans les cases 16. En conséquence, ces domaines transitoires sont très longs, ce qui permet d'obtenir une densité de stockage de l'information très importante.

A titre d'exemple, on peut réaliser la bobine 40, ou le solénoïde 50, avec des conducteurs disposés selon un pas de 50 à 100 μm. Avec une amplitude de courant de 100 mA, on crée un champ auxiliaire externe de 12 Oersted. Pour une couche magnétique douce 7 de 1 500 Å d'épaisseur en alliage amorphe de $Ni_{50}Co_{40}P_{10}$, déposée chimiquement sans courant en voie humide, avec une densité d'énergie de parois de 1,7 erg/cm², on réalise un registre 1 selon l'invention possédant une densité de 130 000 bits/cm². A partir d'un alliage sensiblement différent et une épaisseur plus faible, la densité peut être supérieure à 250 000 bits/cm². La magnétorésistance 33 est constituée par un conducteur également en forme de grecque, an alliage de $Ni_{86}Fe_{14}$, de 2 000 Å d'épaisseur. La lecture de la case 31 est effectuée en 0,5 µs. Pendant un temps d'horloge de 1 µs, on effectue une écriture dans la zone du registre 1, une lecture dans la zone 5, et toute l'information contenue dans le registre 1 se décale d'un pas.

La structure du registre 1, telle qu'elle est décrite ci-dessus, est particulièrement adaptée pour l'intégration complète d'une mémoire, avec ses circuits d'accès (générateur de courant d'écriture, générateur ou interrupteur de courant de décalage, amplificateur de lecture, logique de contrôle), sur une pastille monolithique de circuit intégré classique. Cette intégration peut être effectuée sur tranche de silicium, corindon, etc., en déposant d'abord les circuits d'accès sur cette tranche de semi-conducteur, en les protégeant ensuite, par exemple par une couche de verre, puis en déposant la structure magnétique sur la même tranche, de la manière décrite ci-dessus.

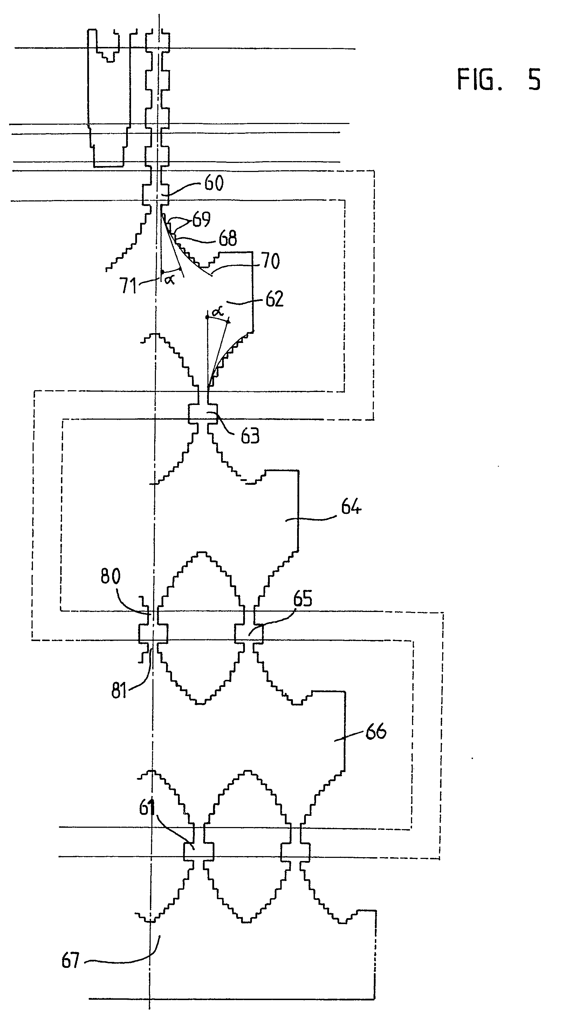

La forme de réalisation de la figure 5 de la zone d'éclatement des domaines diffère de celle de la figure 1. Elle permet d'éviter un risque et présente un avantage supplémentaire.

Tout d'abord, les petits côtés décrochés des cases d'élargissement 23 et 26 de la première forme de réalisation décrite, sur lesquels s'accumulent les charges magnétostatiques, sont relativement longs par rapport aux côtés correspondants des autres cases de croissance du registre. Il en résulte un risque de nucléation des domaines, que la forme de réalisation de la figure 5 élimine. En effet, les décrochements latéraux de cette forme-ci, au lieu d'être perpendiculaires sur toute leur longueur à l'axe aisé de la couche magnétique douce, comme ceux de la figure 1, ont une forme générale courbe et se raccordent progressivement à une case élargie classique, en amont ou en aval de celle-ci suivant le décrochement considéré, en faisant un angle relativement faible avec la direction d'anisotropie de la couche douce. L'angle optimal de raccordement est voisin de 30°. Toutefois, pour qu'un champ démagnétisant soit créé dans ces cases d'élargissement, pour l'effacement des domaines, il est nécessaire de former localement de petits décrochements véritablement perpendiculaires à la direction d'anisotropie, pour que des charges magnétostatiques s'y accumulent.

Ainsi, la zone d'éclatement des domaines de la figure 5 part d'une case élargie classique 60 et aboutit à quatre cases élargies classiques 61. Entre ces cases, le canal de propagation se divise une première fois en deux, à la sortie de la première grande case d'élargissement 62, pour aboutir à deux cases élargies classiques 63. En aval des cases 63, le canal de propagation se divise une seconde fois en trois, à la sortie de la deuxième grande case d'élargissement 64, pour aboutir à trois cases élargies classiques 65. Enfin, entre les cases 65 et 61, le canal de propagation comporte une troisième grande case d'élargissement 66, à quatre sorties, qui vont remplir la case de lecture 67.

L'une des particularités de cette zone d'éclatement, comme on l'a vu plus haut, réside dans le fait que chaque décrochement latéral, par exemple le décrochement 68 de la case 62, est en réalité constitué par une série de petits décrochements 69 perpendiculaires à la direction d'anisotropie et décalés dans le sens de propagation des domaines, pour former une ligne courbe progressive 70 faisant un angle $\alpha$ assez faible avec la direction d'anisotropie 71. A chaque case élargie classique sont raccordés deux décrochements progressifs amont et deux décrochements progressifs aval.

La seconde particularité de la zone d'éclatement de la figure 5 réside dans le fait que chaque case élargie classique 60, 63, 65 et 61 est associée, en amont, à une case rétrécie de stockage normale 80 et, en aval, à une case rétrécie 81 trop courte pour conserver les domaines, contrairement aux cases rétrécies aval de la figure 1. Il en résulte l'avantage, outre l'élimination de tout danger de nucléation de domaines, que les domaines ne sont plus bloqués à l'entrée des grandes cases d'élargissement des domaines, c'est-à-dire en aval des cases élargies classiques, et qu'on élimine ainsi un passage de conducteur de décalage, en l'espèce celui qui, dans la forme de réalisation de la figure 1, passait au-dessus des cases rétrécies de stockage situées en aval des cases élargies classiques.

Grâce à la forme de réalisation de la zone d'éclatement de la figure 5, il est tout à fait possible, selon le schéma de la figure 6, d'intégrer plusieurs registres 90, 91, 92, par exemple, sur un même substrat, en imbriquant leurs zones d'éclatement les unes dans les autres, et en ne formant qu'une seule zone de lecture, avec une seule case de lecture 93, et par conséquent une seule magnétorésistance de lecture. Cette intégration procure un gain de place important. On peut aussi fabriquer une mémoire de 64 k, avec 16 registres de 4 k, ou de 256 k, avec 32 registres de 8 k.

**Revendications**

1. Registre à décalage pour mémoire à propagation de domaines magnétiques, comportant une couche (7) mangétique douce dans laquelle s'effectue la propagation des domaines, une couche (8) magnétique dure et un conducteur (10) de décalage des domaines, le canal (12) de propagation des domaines dans la couche douce étant défini par une interruption de la couche dure, et comprenant des zones (15) rétrécies de stockage des domaines, de cases (16) élargies de croissance des domaines, une case (2) d'écriture, une case (31) de lecture, une zone (4) d'élargissement des domaines, en amont de la case de lecture, comportant des cases (23, 26) intermédiaires d'élargissement des domaines séparées entre elles, dans le sens de la propagation des domaines, par des zones (22, 25) de stockage, et le conducteur de décalage, en forme de grecque, comportant des segments (13, 13') perpendiculaires au canal de propagation, registre caractérisé par le fait que les cases (23, 26) d'élargissement intermédiaires ont une surface importante par rapport à celle des autres cases (16) de croissance et comportent au moins un décrochement (24, 27, 28) latéral, qu'elles ne sont pas recouvertes par le conducteur de décalage, et qu'il est prévu des moyens (40, 50) pour créer au moins au niveau de la zone d'élargissement et de la case de lecture, un champ magnétique externe pulsé.

2. Registre selon la revendication 1, dans lequel la zone (4) d'élargissement des domaines est recouverte par au moins une paire de segments du conducteur de décalage parcourus respectivement en sens inverses par le courant de décalage, et comporte deux cases (25, 22) rétrécies de stockage des domaines disposées respectivement sous les premier et deuxième segments du conducteur de décalage.

3. Registre selon la revendication 2, dans lequel les cases (23) intermédiaires d'élargissement de la zone d'élargissement ont une forme générale rectangulaire et possèdent des côtés perpendiculaires à l'axe (71) d'anisotropie uniaxiale de la couche douce d'une longueur relativement grande par rapport à celle des côtés correspondants des autres cases de croissance du registre.

4. Registre selon la revendication 1, dans lequel les cases intermédiaires d'élargissement possèdent des décrochements (68) latéraux de forme générale courbe se raccordant progressivement à une case (60) de croissance normale en faisant un angle (α) relativement faible avec la direction (71) d'anisotropie uniaxiale de la couche magnétique douce.

5. Registre selon la revendication 4, dans lequel l'angle (α) de raccordement des décrochements (68) latéraux des cases d'élargissement avec la direction (71) d'anisotropie uniaxiale est voisin de 30°.

6. Registre selon l'une des revendications 4 et 5, dans lequel les décrochements (68) latéraux sont constitués par une série de petits décrochements (69) perpendiculaires à la direction (71) d'anisotropie uniaxiale et décalés dans le sens de propagation des domaines.

7. Registre selon l'une des revendications 4 à 6, dans lequel les cases (65) de croissance normales de la zone d'élargissement des domaines sont associées, en amont, à une case (80) rétrécie de stockage des domaines et, en aval, à une case (81) rétrécie trop courte pour stocker les domaines, seule la case (80) rétrécie de stockage étant recouverte par un segment du conducteur de décalage.

8. Registre selon l'une des revendications 1 à 7, dans lequel les dits moyens (40, 50) sont agencés pour créer un champ magnétique externe pulsé sur tout le registre.

9. Registre selon l'une des revendications 1 à 8, dans lequel le champ magnétique externe est parallèle à la direction de propagation des domaines.

10. Registre selon l'une des revendications 1 à 9, dans lequel lesdits moyens comprennent une bobine (40) plate située en dessous du substrat du registre.

11. Registre selon l'une des revendications 1 à 9, dans lequel lesdits moyens comprennent un solnéoïde (50) aplati entourant le substrat du registre.

12. Mémoire à propagation des domaines magnétiques, caractérisée par le fait qu'elle comporte plusieurs registres (90-92), selon l'une des revendications 4 à 11, intégrés sur un même substrat, et possédant une case (93) de lecture commune.

**Claims**

1. Shift register for magnetic domain propagation memory, comprising a soft magnetic layer (7) in which domain propagation is effected, a hard magnetic layer (8) and a domain shift conductor (10), the domain propagation channel (12) in the soft layer being defined by a discontinuity of the hard layer, and comprising narrow domain storage zones (15), widened domain growth boxes (16), a read-in box (2), a read-out box (3), a domain widening zone (4) upstream of the read-out box, comprising intermediate domain widening boxes (23, 26) separated from one another, in the direction of domain propagation, by storage zones (22, 25) and the shift conductor, in a Greek border pattern, comprising segments (13, 13') perpendicular to the propagation channel, characterized in that the intermediate widening boxes (23, 26) have a large surface with respect to that of the other growth boxes (16) and comprise at least one lateral shoulder (24, 27, 28), they are not covered by the shift conductor, and means (40, 50) are provided for creating, at least at the level of the widening zone and the read-out box, a pulsating external magnetic field.

2. Register according to Claim 1, wherein the domain widening zone (4) is covered by at least one pair of segments of the shift conductor through which the shift current passes in opposite directions respectively, and comprises two narrow domain storage boxes (25, 22) disposed beneath the first and second segments of the shift conductor, respectively.

3. Register according to Claim 2, wherein the intermediate widening boxes (23) of the widening zone are generally rectangular in form and have sides perpendicular to the axis (71) of uniaxial anisotropy of the soft layer with a relatively long length with respect to that of the corresponding sides of the other growth boxes of the register.

4. Register according to Claim 1, wherein the intermediate widening boxes (23) are provided with generally curved lateral shoulders (68) progressively connected to a normal growth box (60) making a relatively small angle (α) with the direction (71) of uniaxial anisotropy of the soft magnetic layer.

5. Register according to Claim 4, wherein the angle (α) of connection of the lateral shoulders (68) of the widening boxes with the direction (71) of uniaxial anisotropy is close to 30°.

6. Register according to one of Claims 4 and 5, wherein the lateral shoulders (68) are constituted by a series of small shoulders (69) perpendicular to the direction (71) of uniaxial anisotropy and shifted in the direction of domain propagation.

7. Register according to one of Claims 4 to 6, wherein the normal growth boxes (65) of the domain widening zone are associated, upstream, with a narrow domain storage box (80) and, downstream, with a narrow box (81) too short to store the domains, only the narrow storage box (80) being covered by a segment of the shift conductor.

8. Register according to one of Claims 1 to 7, wherein said means (40, 50) are arranged to create a pulsating external magnetic field over the whole of the register.

9. Register according to one of Claims 1 to 8, wherein the external magnetic field is parallel to the direction of domain propagation.

10. Register according to one of Claims 1 to 9, wherein said means comprise a flat coil (40) located beneath the substrate of the register.

11. Register according to one of Claims 1 to 9, wherein said means comprise a flattened solenoid (50) surrounding the substrate of the register.

12. Magnetic domain propagation memory characterized in that it comprises a plurality of the registers (90-92) according to one of Claims 4 to 11, integrated on a same substrate and having a common read-out box (93).

**Ansprüche**

1. Schieberegister für Domänen-Magnetspeicher mit einer weichmagnetischen Schicht (7) in der die Fortpflanzung der Domänen stattfindet, einer hartmagnetischen Schicht (8) und einem Domänen-Verschiebungsleiter (10), wobei der Verschiebungskanal (12) für die Fortpflanzung der Domänen in der weichmagnetischen Schicht durch eine Unterbrechung der hartmagnetischen Schicht definiert ist, und reduzierte Zonen (15) zur Speicherung der Domänen sowie erweiterte Fächer (16) zur Vergrößerung der Domänen enthält, und mit einem Einschreibefach (12), einem Auslesefach (31), einer stromaufwärts zum Auslesefach gelegenen Erweiterungszone (4) für die Domänen, die Zwischenfächer (23, 26) zur Erweiterung der Domänen aufweist, welche in Fortpflanzungsrichtung der Domänen durch Speicherzonen (22, 25) von einander getrennt sind, und einem mäanderförmigen Verschiebungsleiter, der senkrecht zum Fortpflanzungskanal angeordnete Segmente (13, 13') aufweist, wobei das Register durch die Tatsache gekennzeichnet ist. daß die Zwischenfächer (23, 26) zur Erweiterung eine gegenüber der Oberfläche der anderen Fächer (16) zur Vergrößerung bedeutende Oberfläche besitzen und mindestens eine seitliche Versetzung (24, 27, 28) aufweisen, daß sie nicht vom Verschiebungsleiter überdeckt sind und daß Mittel (40, 50) zur Erzeugung eines externen, pulsierenden Magnetfeldes mindestens im Bereich der Erweiterungszone und des Auslesefaches vorgesehen sind.

2. Register nach Anspruch 1, bei dem die Erweiterungszone (4) für die Domänen von mindestens einem, jeweils im entgegengesetzten Sinne vom Verschiebungsstrom durchfloßenen Paar der Segmente des Verschiebungsleiters überdeckt ist und zwei reduzierte Fächer (25, 22) zur Speicherung der Domänen aufweist, die jeweils unter dem ersten und zweiten Segment des Verschiebungsleiters angeordnet sind.

3. Register nach Anspruch 2, bei dem die Zwischenfächer (23) zur Erweiterung in der Erweiterungszone eine im allgemeinen rechteckige Form aufweisen und rechtwinklig zur Achse (71) der einaxialen Anisotropie der weichmagnetischen Schicht angeordnete Seiten besitzen, mit einer Länge, die relativ groß ist im Hinblick auf die Länge der entsprechenden Seiten der anderen Fächer zur Vergrößerung im Register.

4. Register nach Anspruch 1, bei dem die Zwischenfächer (23) zur Erweiterung seitliche Versetzungen (68) aufweisen von im allgemeinen gekrümmter Form, die sich fortlaufend an ein normales Fach (60) zur Vergrößerung anpaßt, indem sie einen relativ kleinen Winkel (α) mit der Richtung (71) der einaxialen Anisotropie der weichmagnetischen Schicht bildet.

5. Register nach Anspruch 4, bei dem der Winkel (α) der Anpassung der seitlichen Versetzung (68) der Fächer zur Erweiterung mit der Richtung (71) der einaxialen Anisotropie in der Nähe von 30° liegt.

6. Register nach einem der Ansprüche 4 und 5, bei dem die seitlichen Versetzungen (68) durch eine Serie von kleinen Versetzungen (69) gebildet werden, die senkrecht zur Richtung (71) der einaxialen Anisotropie verlaufen und in Fortpflanzungsrichtung der Domänen verschoben sind.

7. Register nach einem der Ansprüche 4 bis 6, bei dem die normalen Fächer (65) zur Vergrößerung in der Erweiterungszone für die Domänen stromaufwärts mit einem reduzierten Fach (80) zur Speicherung der Domänen und stromabwärts mit einem reduzierten Fach (81), welches zu kurz zur Speicherung der Domänen ist, verbunden sind, wobei nur das speichernde, reduzierte Fach von einem Segment des Verschiebungsleiters überdeckt ist.

8. Register nach einem der Ansprüche 1 bis 7, bei dem die besagten Mittel (40, 50) so angeordnet sind, daß sie über das ganze Register ein externes, pulsierendes Magnetfeld erzeugen.

9. Register nach einem der Ansprüche 1 bis 8, bei dem das externe Magnetfeld parallel zur Fortpflanzungsrichtung der Domänen verläuft.

10. Register nach einem der Ansprüche 1 bis 9, bei dem die besagten Mittel eine ebene Spule (40) aufweisen, die unterhalb des Substrats des Registers angeordnet ist.

11. Register nach einem der Ansprüche 1 bis 9, bei dem die besagten Mittel ein abgeflachtes Solenoid (50) aufweisen, welches das Substrat des Registers umgibt.

12. Domänen-Magnetspeicher gekennzeichnet durch die Tatsache, daß er mehrere Register (90, 91, 92) nach einem der Ansprüche 4 bis 11 aufweist, die auf einem gemeinsamen Substrat integriert sind und ein gemeinsames Auslesefach besitzen.

FIG. 1

0 029 378

1

FIG. 2

FIG. 6

FIG. 3

FIG. 4

FIG. 5